# EUROPEAN PATENT SPECIFICATION

(11) **EP 0 633 504 B1**
(45) Date of publication and mention of the grant of the patent: **24.04.1996**
(21) Application number: 93201999.5
(22) Date of filing: 08.07.1993
(51) Int. Cl.: G03F 7/07

(54) **Method for making a printing plate according to the silver salt diffusion transfer process**
Verfahren zur Herstellung einer Druckplatte unter Verwendung des Silbersalz-Diffusion-Übertragungsverfahrens
Procédé de préparation d'une plaque d'impression pour le procédé de diffusion-transfert de sel d'argent

(43) Date of publication of application: 11.01.1995
(73) Proprietor: AGFA-GEVAERT naamloze vennootschap, B-2640 Mortsel (BE)
(72) Inventor: Van Rompuy, Ludo, B 2640 Mortsel (BE)

(56) References cited:
- EP-A- 0 549 830
- GB-A- 2 103 382
- PATENT ABSTRACTS OF JAPAN vol. 6, no. 209 (P-150)(1087) 21 October 1982 & JP-A-57 115 549

## Description

### 1. Field of the invention.

The present invention relates to a method for making a lithographic printing plate according to the silver salt diffusion transfer process.

### 2. Background of the invention.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background. For example, typical lithographic printing plates are disclosed e.g. EP-A-423399 and EP-A-410500.

The DTR-image can be formed in the image-receiving layer of a sheet or web material which is a separate element with respect to the photographic silver halide emulsion material (a so-called two-sheet DTR element) or in the image-receiving layer of a so-called single-support-element, also called mono-sheet element, which contains at least one photographic silver halide emulsion layer integral with an image-receiving layer in waterpermeable relationship therewith. It is the latter mono-sheet version which is preferred for the preparation of offset printing plates by the DTR method.

As for other printing plates it is required that the printing plates obtained according to the DTR-process have a high printing endurance, good ink acceptance in the printing areas and no ink acceptance in the non-printing areas (no staining). It is furthermore desirable that the number of copies that have to be disposed of because of ink acceptance in the non-printing areas (so called toning) during start-up of the printing process is limited. With respect to these requirements the state of the transferred silver i.e. the silver formed in the image-receiving layer plays a very important role. Parameters that are known to control the state of the transferred silver are e.g. the rate of development of the exposed silver halide (chemical development), rate of dissolution of the non-exposed silver halide by the silver halide solvent(s), rate of diffusion of the silver halide complexes, rate of development of the silver halide complexes in the image receiving layer (physical development) etc..

In US-P 5.200.294 it has been suggested to use a meso-ionic compound during development to improve the lithographic properties of the resulting printing plate. According to this disclosure the meso-ionic compound may be used in combination with an alkanolamine. The use of meso-ionic compounds for developing DTR-printing plates was also suggested in EP-A-535678 and EP-A-549830.

GB-A-2103382 discloses that a good printing endurance of a printing plate having a low silver content can be obtained by developing the plate in the presence of a specific thione compound.

However it was found that the lithographic properties of printing plates obtained using a meso-ionic compound during development are too much dependent upon the degree of exhaustion of the alkaline processing liquid i.e. upon the amount of printing plates that were already processed with the same processing liquid.

### 3. Summary of the invention.

It is an object of the present invention to decrease the dependance of the lithographic properties of printing plates, obtained according to the DTR-process using a meso-ionic compound during development, upon the exhaustion of the alkaline processing liquid.

Further objects will become clear from the description hereinafter.

According to the present invention there is provided a method for making a lithographic printing plate comprising the steps of:
- image-wise exposing an imaging element comprising on a support a silver halide emulsion layer and a layer containing physical development nuclei and
- developing a thus obtained image-wise exposed imaging element using an alkaline processing liquid in the presence of a meso-ionic compound and a developing agent;
characterized in that said imaging element comprises silver halide expressed as AgNO₃ in an amount of 0.7g/m to 1.3g/m.

### 4. Detailed description of the invention

Meso-ionic compounds as referred to in the present invention are a group of compounds defined by W. Baker and W.D. Ollis as "5- or 6-membered heterocyclic compounds which cannot be represented satisfactorily by any one covalent or polar structure and possesses a sextet of π-electrons in association with the atoms comprising the ring. The ring bears a fractional positive charge balanced by a corresponding negative charge located on a covalently attached atom or group of atoms" as described in Quart. Rev., Vol. 11, p. 15 (1957) and Advances in Heterocyclic Chemistr, Vol. 19, P. 4 (1976).

Preferred meso-ionic compounds are those represented by formula (I): 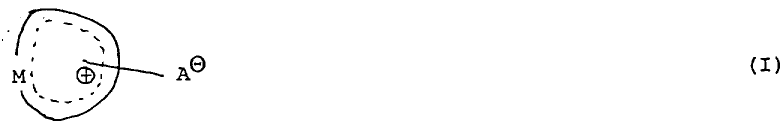 wherein M represents a 5- or 6-membered heterocyclic ring composed of at least one member selected from the group consisting of a carbon atom, a nitrogen atom, an oxygen atom, a sulfur atom and a selenium atom; and A^{Θ} represents -O^{Θ}, -S^{Θ} or -N^{Θ}-R, wherein R represents an alkyl group (preferably having 1 to 6 carbon atoms), a cycloalkyl group (preferably having 3 to 6 carbon atoms), an alkenyl group (preferably having 2 to 6 carbon atoms) an alkynyl group (preferably having 2 to 6 carbon atoms), an aralkyl group, an aryl group (preferably having 6 to 12 carbon atoms), or a heterocyclic group (preferably having 1 to 6 carbon atoms).

In formula (I), examples of the 5-membered heterocyclic ring as represented by M include an imidazolium ring, a pyrazolium ring, an oxazolium ring, an isoxazolium ring, a thiazolium ring, an isothiazolium ring, a 1,3-dithiol ring, a 1,3,4- or 1,2,3 oxadiazolium ring, a 1,3,2-oxathiazolium ring, a 1,2,3-triazolium ring, a 1,3,4-triazolium ring, a 1,3,4-, 1,2,3- or 1,2,4-thiadiazolium ring, a 1,2,3,4-oxatriazolium ring, a 1,2,3,4-tetrazolium ring and a 1,2,3,4-thiatriazolium ring.

Preferred meso-ionic compounds for use in accordance with the present invention are triazolium thiolates and more preferably 1,2,4-triazolium-3-thiolates and most peferably those that correspond to the following formula: 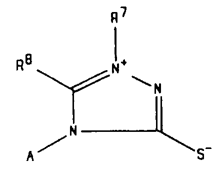 wherein R⁷ and R⁸ each independently represents an alkyl group, alkenyl group, cycloalkyl group, aralkyl group, aryl group or heterocyclic group each of which groups may be substituted or not, A represents an alkyl group, alkenyl group, cycloalkyl group, aralkyl group, aryl group, heterocyclic group each of which groups may be substituted or represents -NR⁹R¹⁰ wherein R⁹ and R¹⁰ each independently represents hydrogen, a substituted or unsubstituted alkyl group or a substituted or unsubstituted aryl group or wherein R⁷ and R⁸ or R⁸ and A or R⁹ and R¹⁰ together with the atoms to which they are attached represent the necessary atoms to form a 5- or 6-membered ring.

Specific examples of 1,2,4-triasolium-3-thiolates suitable for use in accordance with the present invention are shown in table 1.

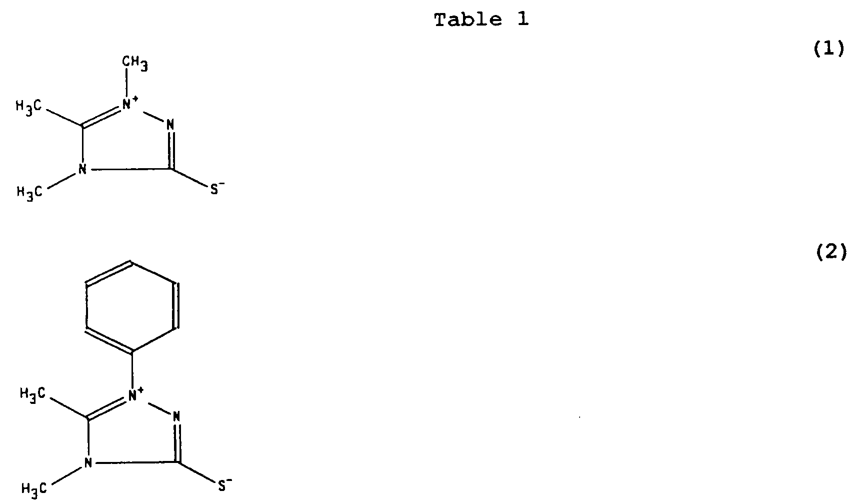

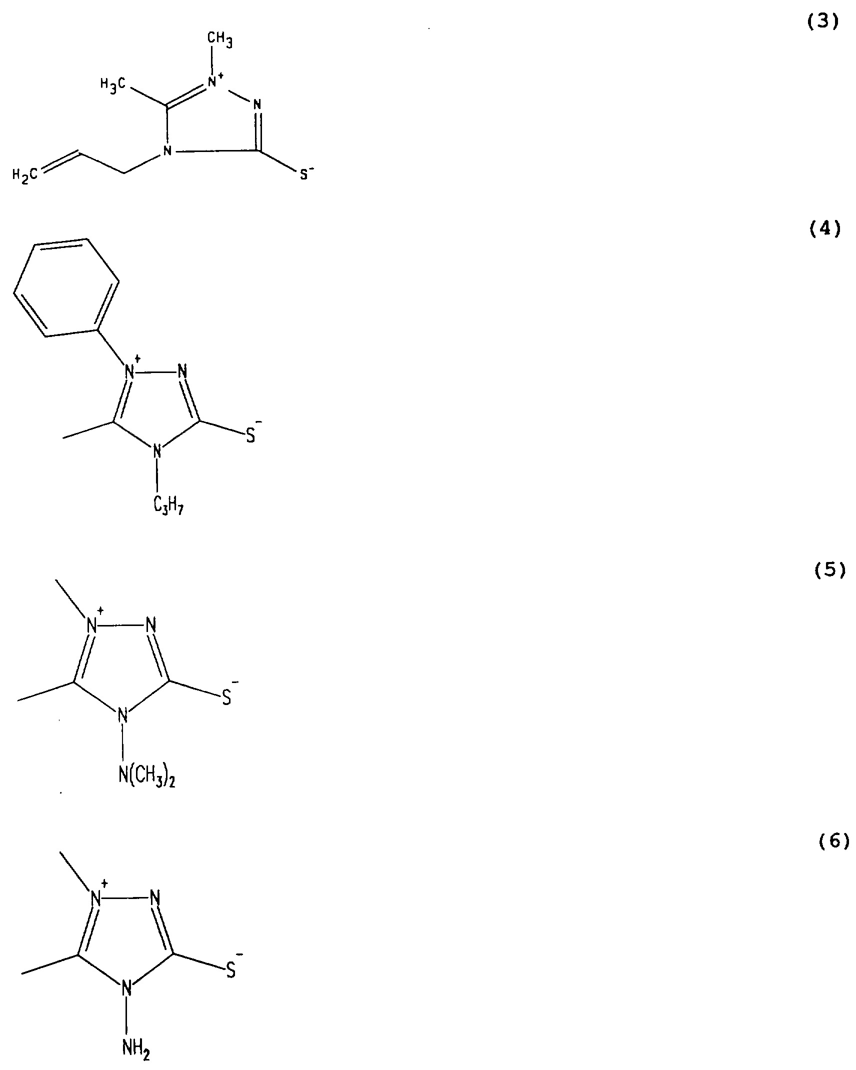

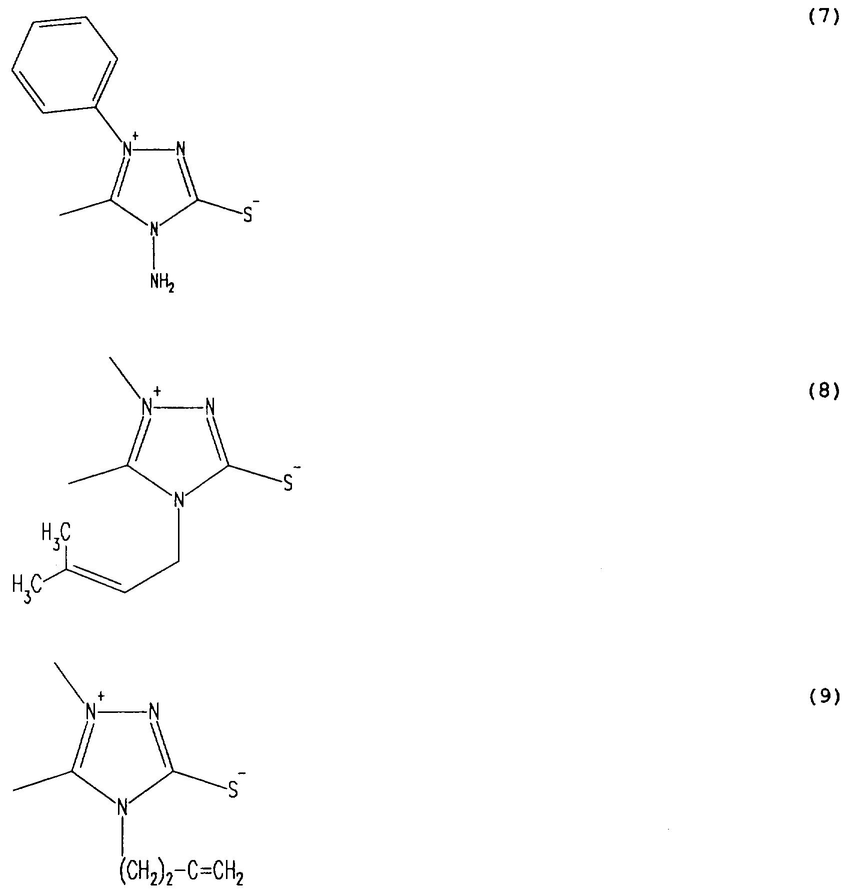

According to a preferred embodiment of the present invention at least part and most preferably all of the meso-ionic compound is preferably present in the alkaline processing liquid used for developing the image-wise exposed imaging element. Preferably the amount of meso-ionic compound in the alkaline processing liquid is between 0.1 mmol/l and 25 mmol/l and more preferably between 0.5 mmol/l and 10 mmol/l and most preferably between 1 mmol/l and 5 mmol/l.

However the meso-ionic compound may be incorporated in one or more layers comprised on the support of the imaging element. This offers the advantage of replenishment of said meso-ionic compound in the alkaline processing liquid. Preferably the meso-ionic compound is incorporated in a layer of the imaging element that does not contain silver halide such as e.g. in a backing layer, in the image receiving layer, a subbing layer etc.. The meso-ionic compound is preferably contained in the imaging element in a total amount between 0.1 and 10mmol/m, more preferably between 0.1 and 0.5mmol/m and most preferably between 0.5 and 1.5mmol/m.

Most preferably, the alkaline processing solution also contains an alkanolamine. Alkanolamines that are suitable for use in accordance with the present invention may be of the tertiary, secundary or primary type. Examples of alkanolamines that may be used in connection with the present invention correspond to the following formula: 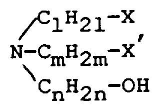 wherein X and X' independently represent hydrogen, a hydroxyl group or an amino group, 1 and m represent 0 or integers of 1 or more and n represents an integer of 1 or more. Preferably used alkanolamines are e.g. N-(2-aminoethyl)ethanolamine, diethanolamine, N-methylethanolamine, triethanolamine, N-ethyldiethanolamine, diisopropanolamine, ethanolamine, 4-aminobutanol, N,N-dimethylethanolamine, 3-aminopropanol, N,N-ethyl-2,2'-iminodiethanol etc. or mixtures thereof.

The alkanolamines are preferably used in a concentration of 0.05% to 10% by weight and more preferably in a concentration of 0.05% by weight to 7% by weight.

The alkaline processing liquid can comprise further silver halide solvents. Additional silver halide solvents for use in connection with the present invention are e.g. 2-mercaptobenzoic acid, cyclic imides, oxazolidones, thiocyanates, thioethers and thiosulfates.

Preferably used thioethers correspond to the following general formula:

Z-(R¹-S)ₜ-R-S-R³-Y

wherein Z and Y each independently represents hydrogen, an alkyl group, an amino group, an ammonium group, a hydroxyl, a sulfo group, a carboxyl, an aminocarbonyl or an aminosulfonyl, R¹, R and R³ each independently represents an alkylene that may be substituted and optionally contain a oxygen bridge and t represents an integer from 0 to 10.

Examples of thioether compounds corresponding to the above formula are disclosed in e.g. US-P-4.960.683 and specific examples are listed in table 2

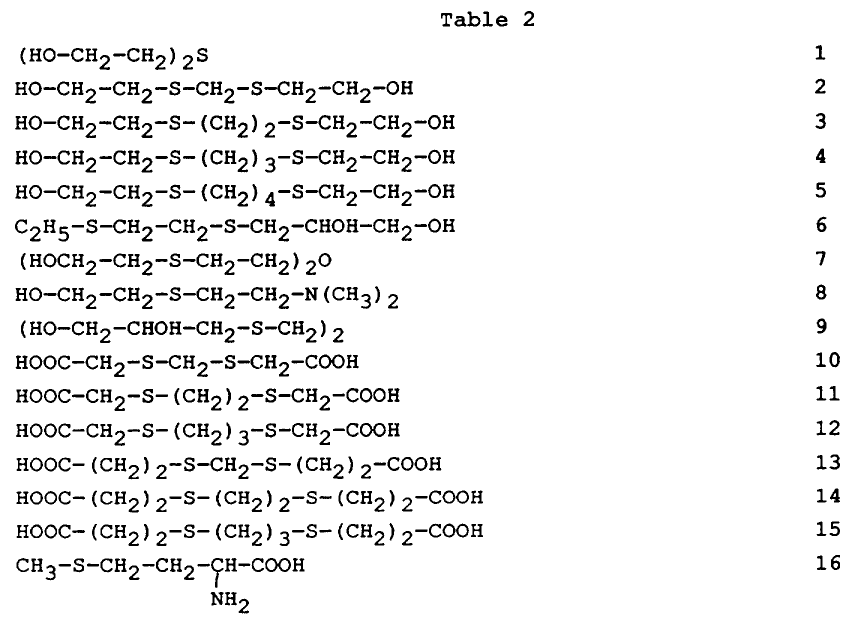

Preferably the silver halide solvent is used in an amount between 0.05% by weight and 10% by weight and more preferably between 0.05% by weight and 7% by weight.

According to the present invention the alkaline processing liquid preferably also contains hydrophobizing agents for improving the hydrophobicity of the silver image obtained in the image receiving layer. The hydrophobizing agents used in connection with the present invention are compounds that are capable of reacting with silver or silver ions and that are hydrophobic i.e. insoluble in water or only slightly soluble in water. Generally these compounds contain a mercapto group or thiolate group and one or more hydrophobic substituents e.g. an alkyl group containing at least 3 carbon atoms. Examples of hydrophobizing agents for use in accordance with the present invention are e.g. those described in US-P 3,776,728, and US-P 4,563,410. Particularly preferred hydrophobizing agents in connection with the present invention are long chain (at least 5 carbon atoms) alkyl substituted mercaptotetrazoles, mercaptotriazoles and mercapto-oxadiazoles.

According to the present invention the hydrophobizing agents may be contained in the alkaline processing liquid in an amount of at least 0.1g/l, more preferably at least 0.2g/l and most preferably at least 0.3g/l. The maximum amount of hydrophobizing agents will be determined by the type of hydrophobizing agent, type and amount of silver halide solvents etc.. Typically the concentration of hydrophobizing agent is preferably not more than 1.5g/l and more preferably not more than 1g/l.

The alkaline processing liquid used in accordance with the present invention preferably has a pH between 9 and 14 and more preferably between 10 and 13. Said pH may be established by an organic or inorganic alkaline substance or a combination thereof. Suitable inorganic alkaline substances are e.g. potassium or sodium hydroxide, carbonate, phosphate etc.. Suitable organic alkaline substances are e.g. alkanolamines. In the latter case the alkanolamines will provide or help maintain the pH and serve as a silver halide complexing agent. The present invention allows the use of alkaline processing liquids of low pH (11 or less) to be used.

The alkaline processing liquid may also contain (a) developing agent(s). In this case the alkaline processing liquid is called a developer. On the other hand some or all of the developing agent(s) may be present in one or more layers of the photographic material or imaging element. When all of the developing agents are contained in the imaging element the alkaline processing liquid is called an activator or activating liquid.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. Preferred phenidone type developing agents, particularly when they are incorporated into the photographic material are phenidones of which the aqueous solubility is increased by a hydrophilic substituent such as e.g. hydroxy, amino, carboxylic acid group, sulphonic acid group etc. Examples of phenidones subsituted with one or more hydrophilic groups are e.g. 1-phenyl-4,4-dimethyl-2-hydroxy-3-pyrazolidone, 1-(4-carboxyphenyl)-4,4-dimethyl-3-pyrazolidone etc.. However other developing agents can be used.

At least the auxiliary developing agents are preferably incorporated into the photographic material. The auxiliary developing agent is preferably incorporated in the photographic material, preferably in the silver halide emulsion layer of the photographic material, in an amount of less than 150mg/g of silver halide expressed as AgNO₃, more preferably in an amount of less than 100mg/g of silver halide expressed as AgNO₃.

The alkaline processing liquid preferably also contains a preserving agent having antioxidation activity, e.g. sulphite ions provided e.g. by sodium or potassium sulphite. For example, the aqueous alkaline solution comprises sodium sulphite in an amount ranging from 0.15 to 1.0 mol/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners. In accordance with the present invention it is furthermore preferred to use a spreading agent or surfactant in the alkaline processing liquid to assure equal spreading of the alkaline processing liquid over the surface of the photographic material. Such a surfactant should be stable at the pH of the alkaline processing liquid and should assure a fast overall wetting of the surface of the photographic material. A surfactant suitable for such purpose is e.g. a fluor containing surfactant such as e.g. C₇F₁₅COONH₄. It is furthermore advantageous to add glycerine to the alkaline processing liquid so as to prevent crystallization of dissolved components of said alkaline processing liquid.

Development acceleration can be accomplished with the aid of various compounds to the alkaline processing liquid and/or one or more layers of the photographic element, preferably polyalkylene derivatives having a molecular weight of at least 400 such as those described in e.g. US-P 3,038,805 - 4,038,075 - 4,292,400 - 4,975,354.

Subsequent to the development in an alkaline processing liquid the surface of the printing plate is preferably neutralized using a neutralization liquid.

A neutralization liquid generally has a pH between 5 and 7. The neutralization liquid preferably contains a buffer e.g. a phosphate buffer, a citrate buffer or mixture thereof. The neutralization solution can further contain bactericides, e.g. phenol, thymol or 5-bromo-5-nitro-1,3-dioxan as described in EP 0,150,517. The liquid can also contain substances which influence the hydrophobic / hydrophilic balance of the printing plate obtained after processing of the DTR element, e.g. silica. Further the neutralization solution can contain wetting agents, preferably compounds containing perfluorinated alkyl groups.

The image-wise exposure in connection with the present invention may be a camera exposure but may also be a scan-wise exposure e.g. by means of a laser or LED.

A photographic material for use in connection with the method of the present invention comprises on a support in the order given a silver halide emulsion layer and a layer containing physical development nuclei wherein the amount of silver halide expressed as AgNO₃ is 1.3g/m or less. The minimum amount of silver halide is not particularly critical but is preferably not less than 0.7 g/m to assure a strong silver mirror in the printing areas.

The weight ratio of the amount of hydrophilic colloid to silver in the silver halide emulsion layer is preferably not more than 1.2 and more preferably not more than 1.

Supports suitable for use in accordance with the present invention may be opaque or transparent, e.g. a paper support or resin support. When a paper support is used preference is given to one coated at one or both sides with an Alpha-olefin polymer, e.g. a polyethylene layer which optionally contains an anti-halation dye or pigment. It is also possible to use an organic resin support e.g. cellulose nitrate film, cellulose acetate film, poly(vinyl acetal) film, polystyrene film, poly(ethylene terephthalate) film, polycarbonate film, polyvinylchloride film or poly-Alpha-olefin films such as polyethylene or polypropylene film. The thickness of such organic resin film is preferably comprised between 0.07 and 0.35 mm. These organic resin supports are preferably coated with a hydrophilic adhesion layer which can contain water insoluble particles such as silica or titanium dioxide. Metal supports e.g. aluminium may also be used in accordance with the present invention.

The image receiving layer containing physical development nuclei is preferably free of hydrophilic binder but may comprise small amounts upto 30% by weight of the total weight of said layer of a hydrophilic colloid e.g. polyvinyl alcohol to improve the hydrophilicity of the surface. Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are salts such as e.g. selenides, polyselenides, polysulphides, mercaptans, and tin (II) halides. Heavy metals, preferably silver, gold, platinum, palladium, and mercury can be used in colloidal form.

The photographic silver halide emulsion(s) used in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The photographic silver halide emulsions used according to the present invention can be prepared by mixing the halide and silver solutions in partially or fully controlled conditions of temperature, concentrations, sequence of addition, and rates of addition. The silver halide can be precipitated according to the single-jet method or the double-jet method.

The silver halide particles of the photographic emulsions used according to the present invention may have a regular crystalline form such as a cubic or octahedral form or they may have a transition form. They may also have an irregular crystalline form such as a spherical form or a tabular form, or may otherwise have a composite crystal form comprising a mixture of said regular and irregular crystalline forms.

According to the present invention the emulsion or emulsions preferably consist principally of silver chloride while a fraction of silver bromide may be present ranging from 1 mole % to 40 mole %. Most preferably the amount of bromide is kept below 5 mole %. The emulsions may further contain silver iodide in an amount of upto 5 mole % preferably upto 2 mole %.

The average diameter of the silver halide grains may range from 0.10 to 0.70 µm , preferably from 0.25 to 0.6 µm.

The size distribution of the silver halide particles of the photographic emulsions to be used according to the present invention can be homodisperse or heterodisperse. A homodisperse size distribution is obtained when 95% of the grains have a size that does not deviate more than 30% from the average grain size.

Preferably during the precipitation stage Iridium and/or Phodium containing compounds or a mixture of both are added. The concentration of these added compounds ranges from 10⁻⁸ to 10⁻³ mole per mole of AgNO₃, preferably between 10⁻⁷ and 10⁻⁶ mole per mole of AgNO₃. This results in the building in in the silver halide crystal lattice of minor amounts of Iridium and/or Rhodium, so-called Iridium and/or Rhodium dopants. As known to those skilled in the art numerous scientific and patent publications disclose the addition of Iridium or Rhodium containing compounds or compounds containing other elements of Group VIII of the Periodic System during emulsion preparation.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The emulsions of the DTR element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

The silver halide emulsions may contain the usual stabilizers e.g. homopolar or salt-like compounds of mercury with aromatic or heterocyclic rings such as mercaptotriazoles, simple mercury salts, sulphonium mercury double salts and other mercury compounds. Other suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives, and benzotriazole. Preferred compounds are mercapto substituted pyrimidine derivatives as disclosed in US-P 3,692,527.

The silver halide emulsions may contain pH controlling ingredients. Preferably the emulsion layer is coated at a pH value below the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217.

In an especially preferred embodiment the emulsion layer contained in the imaging element contains a compound which comprises in its molecular structure a group capable of adsorbing to silver halide and a group capable of reducing silver halide. Compounds of this kind have been disclosed in EP-A-449340. In this way a combination of a stabilizing and a development activating function in one compound is achieved.

More details about the composition, preparation and coating of silver halide emulsions can be found in e.g. Product Licensing Index, Vol. 92, December 1971, publication 9232, p. 107-109.

In addition to the above described emulsion layer and image receiving layer other hydrophilic colloid layers in water permeable relationship with these layers may be present. For example it is especially advantageous to include a base-layer between the support and the photosensitive silver halide emulsion layer. In a preferred embodiment of the present invention said base-layer serves as an antihalation layer. This layer can therefore contain the same light-absorbing dyes as described above for the emulsion layer ; as alternative finely divided carbon black can be used for the same antihalation purposes as described in US-P 2,327,828. On the other hand, in order to gain sensitivity, light reflecting pigments, e.g. titaniumdioxide can be present. Further this layer can contain hardening agents, matting agents, e.g. silica particles, and wetting agents. At least part of these matting agents and/or light reflection pigments may also be present in the silver halide emulsion layer the major part however preferably being present in said base-layer. As a further alternative the light reflecting pigments may be present in a separate layer provided between the antihalation layer and the photosensitive silver halide emulsion layer.

In a preferred embodiment in connection with the present invention a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a double layer pack.

The hydrophilic layers usually contain gelatin as hydrophilic colloid binder. Mixtures of different gelatins with different viscosities can be used to adjust the rheological properties of the layer. Like the emulsion layer the other hydrophilic layers are coated preferably at a pH value below the isoelectric point of the gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.

The hydrophilic layers of the photographic element, especially when the binder used is gelatin, can be hardened with appropriate hardening agents such as those of the epoxide type, those of the ethylenimine type, those of the vinylsulfone type e.g. 1,3-vinylsulphonyl-2-propanol, methylenebis (sulfonylethylene), chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

Preferably used hardening agents are of the aldehyde type. The hardening agents can be used in wide concentration range but are preferably used in an amount of 4% to 7% of the hydrophilic colloid. Different amounts of hardener can be used in the different layers of the imaging element or the hardening of one layer may be adjusted by the diffusion of a hardener from another layer.

The imaging element used according to the present invention may further comprise various kinds of surface-active agents in the photographic emulsion layer or in at least one other hydrophilic colloid layer. Suitable surface-active agents include non-ionic agents such as saponins, alkylene oxides e.g. polyethylene glycol, polyethylene glycol/polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Preferably compounds containing perfluorinated alkyl groups are used. Such surface-active agents can be used for various purposes e.g. as coating aids, as compounds preventing electric charges, as compounds improving slidability, as compounds facilitating dispersive emulsification and as compounds preventing or reducing adhesion.

The photographic material of the present invention may further comprise various other additives such as e.g. compounds improving the dimensional stability of the photographic element, UV-absorbers, spacing agents and plasticizers.

Suitable additives for improving the dimensional stability of the photographic element are e.g. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids.

According to another embodiment of the present invention a lithographic printing plate can be obtained by means of the DTR-process process using an imaging element comprising in the order given a grained and anodized aluminium support, an optional layer of physical development nuclei and a silver halide emulsion layer wherein the amount of silver halide expressed as AgNO₃ does not exceed 1.3g/m. The imaging element of the present embodiment may be imaged using a camera-exposure or a scanning exposure as described above followed by a development step in the presence of development agent(s) and silver halide solvent(s) according to the invention so that a silver image is formed in the physical development nuclei layer or directly on the aluminium support. Subsequently the silver halide emulsion layer and any other optional hydrophilic layers are removed by rinsing the imaged element with water so that the silver image is exposed. Finally the hydrophobic character of the silver image is preferably improved using a finishing liquid comprising hydrophobizing agents as described above.

The present invention will now be illustrated by way of the following examples without however the intention to limit the invention thereto. All parts are by weight unless otherwise specified.

### EXAMPLE 1

### Preparation of the silver halide emulsion coating solution.

A silver chlorobromide emulsion composed of 98.2mole% of chloride and 1.8mole% of bromide was prepared by the double jet precipitation method. The average silver halide grain size was 0.4µm (diameter of a sphere with equivalent volume) and contained Rhodium ions as internal dopant. The emulsion was orthochromatically sensitized and stabilized by 1-phenyl-5-mercaptotetrazole.

A base layer coating solution was prepared having the following composition:

| | |
|---|---|
| gelatin | 5.5% |
| carbon black | 0.76% |
| silica particles (5µm) | 1.6% |

### Preparation of a comparative tokeimaging element:

The emulsion coating solution and base layer coating solution were simultaneously coated by means of the cascade coating technique to a polyethylene terephthalate support provided with a pack of two backing layers such that the base layer coating was coated directly to the side of the support opposite to the side containing said backing layers. The emulsion layer was coated such that the silver halide coverage expressed as AgNO₃ was 1.5g/m and the gelatin content was 1.5g/m. The emulsion layer further contained 0.15g/m of 1-phenyl-4,4'-dimethyl-3-pyrazolidone and 0.25g/m of hydroquinone. The base layer was coated such that the amount of gelatin in the coated layer was 3g/m.

The layer nearest to the support of the backing layer pack contained 0.3 g/m of gelatin and 0.5 g/m of the antistatic agent co(tetraallyloxyethane / methacrylate / acrylic acid-K-salt) polymer. The second backing layer contained 4 g/m of gelatin, 0.15 g/m of a matting agent consisting of transparent spherical polymeric beads of 3 micron average diameter according to EP 0080225, 0.05 g/m of hardening agent triacrylformal and 0.021 g/m of wetting agent F₁₅C₇-COONH₄.

The thus obtained element was dried and subjected to a temperature of 40°C for 5 days and then the emulsion layer was overcoated with a layer containing PdS as physical development nuclei, hydroquinone at 0.4g/m and formaldehyde at 100mg/m.

An imaging element according to the invention was prepared similar to the comparative imaging element with the exception that instead of 1.5g/m of silver halide expressed as AgNO₃ 1g/m was used. The amount of gelatin in the silver halide emulsion layer and hydroquinone were reduced in order to keep their relative amount to the silver halide constant.

The following processing solutions were prepared :

### Activator (alkaline processing liquid)

| | |
|---|---|
| sodium hydroxide (g) | 30 |
| sodium sulphite anh. (g) | 35 |
| compound 3 of table 1 (mg) | 750 |
| 2-aminoethyl-aminoethanol (ml) | 25 |
| 2-mercapto-5-n.heptyl-oxa-3,4-diazole (mg) | 250 |
| water to make | 1000ml |

Neutralization solution

| | |
|---|---|
| citric acid | 10 g |
| sodium citrate | 35 g |
| sodium sulphite anh. | 5 g |
| phenol | 50 mg |
| water to make | 1000ml |

Dampening solution

| | |
|---|---|
| water | 880 ml |
| citric acid | 6g |
| boric acid | 8.4g |
| sodium sulphate anh. | 25g |
| ethyleneglycol | 100g |
| colloidal silica | 28g |

10m of each of the above prepared imaging elements was image-wise exposed and processed at 30°C using the above activator. The first imaging element of each of the different imaging elements was processed in a freshly prepared activator and no replenishement of the activator took place for processing the 10m of imaging element.

Subsequent to the development the plates were neutralized using the above neutralization liquid. The first and last printing plate obtained for each of the different imaging elements was then used to print on a Heidelberg GTO-52 printing press. The above described dampening liquid was used during printing.

The printing endurance, i.e. the number of acceptable copies, for the first and the last plate obtained with each of the different imaging elements was evaluated. The results obtained are as follows:

| | | Printing endurance |
|---|---|---|
| Silver halide content | First plate | Last plate (after 10m) |
| 1.5g/m | > 10000 | 5000-10000 |
| 1.0g/m | > 10000 | > 10000 |

## Claims

1. A method for making a lithographic printing plate comprising the steps of:
- image-wise exposing an imaging element comprising on a support a silver halide emulsion layer and a layer containing physical development nuclei and
- developing a thus obtained image-wise exposed imaging element using an alkaline processing liquid in the presence of a meso-ionic compound and a developing agent;
characterized in that said imaging element comprises silver halide in an amount expressed as AgNO₃ of 0.7g/m to 1.3g/m.

2. A method according to claim 1 wherein said meso-ionic compound is present in said alkaline processing liquid.

3. A method according to claim 2 wherein said meso-ionic compound corresponds to the following formula: 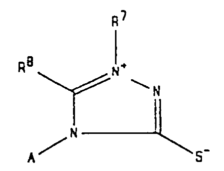 wherein R⁷ and R⁸ each independently represents an alkyl group, alkenyl group, cycloalkyl group, aralkyl group, aryl group or heterocyclic group each of which groups may be substituted or not; A represents an alkyl group, alkenyl group, cycloalkyl group, aralkyl group, aryl group, heterocyclic group each of which groups may be substituted or represents -NR⁹R¹⁰ wherein R⁹ and R¹⁰ each independently represents hydrogen, a substituted or unsubstituted alkyl group or a substituted or unsubstituted aryl group or wherein R⁷ and R⁸ or R⁸ and A or R⁹ and R¹⁰ together with the atoms to which they are attached represent the necessary atoms to form a 5- or 6-membered ring.

4. A method according to claim 2 or 3 wherein said alkaline processing liquid further comprises an alkanolamine and/or a thioether.

5. A method according to any of the above claims wherein said alkaline processing liquid comprises a hydrophobizing agent.

6. A method according to claim 5 wherein said hydrophobizing agent is selected from the group consisting of a mercaptotriazole, a mercaptotetrazole and a mercaptooxadiazole.

7. A method according to claim 5 or 6 wherein said alkaline processing liquid comprises a mixture of two or more hydrophobizing agents.

8. A method according to any of the above claims wherein said silver halide emulsion layer comprises a hydrophilic colloid in a weight ratio with respect to the amount of silver halide expressed as AgNO₃ of not more than 1.2.

## Patentansprüche

1. Verfahren zur Herstellung einer lithographischen Druckplatte, das die folgenden Stufen umfaßt :
- die bildmäßige Belichtung eines bilderzeugenden Elements, das auf einem Träger eine Silberhalogenidemulsionsschicht und eine physikalische Entwicklungskeime enthaltende Schicht und
- die Entwicklung eines so erhaltenen bildmäßig belichteten bilderzeugenden Elements unter Anwendung einer alkalischen Verarbeitungsflüssigkeit in Gegenwart einer mesoionischen Verbindung und eines Entwicklers,
dadurch gekennzeichnet, daß das bilderzeugende Element als AgNO₃ ausgedrucktes Silberhalogenid in einer Menge zwischen 0,7 g/m und 1,3 g/m enthält.

2. Verfahren nach Anspruch 1, dadurch gekennzeichnet, daß die mesoionische Verbindung in der alkalischen Verarbeitungsflüssigkeit enthalten ist.

3. Verfahren nach Anspruch 2, dadurch gekennzeichnet, daß die mesoionische Verbindung der folgenden Formel entspricht : 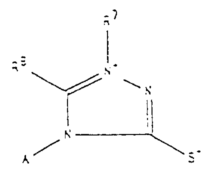 in der bedeuten :
R⁷ und R⁸, unabhängig voneinander, je eine substituierte oder nicht-substituierte Alkylgruppe, Alkenylgruppe, Cycloalkylgruppe, Aralkylgruppe, Arylgruppe oder heterocyclische Gruppe
A eine substituierte oder nicht-substituierte Alkylgruppe, Alkenylgruppe, Cycloalkylgruppe, Aralkylgruppe, Arylgruppe, heterocyclische Gruppe oder -NR⁹R¹⁰, wobei R⁹ und R¹⁰, unabhängig voneinander, je Wasserstoff, eine Alkylgruppe oder eine Arylgruppe bedeuten oder wobei R⁷ und R⁸ oder R⁸ und A oder R⁹ und R¹⁰ zusammen mit den Atomen, an denen sie gebunden sind, die zum Bilden eines fünf- oder sechsgliedrigen Ring benötigten Atome darstellen.

4. Verfahren nach Anspruch 2 oder 3, dadurch gekennzeichnet, daß die alkalische Verarbeitungsflüssigkeit ein Alkanolamin und/oder einen Thioether enthält.

5. Verfahren nach irgendwelchem der vorstehenden Ansprüche, dadurch gekennzeichnet, daß die alkalische Verarbeitungsflüssigkeit ein Hydrophobiermittel enthält.

6. Verfahren nach Anspruch 5, dadurch gekennzeichnet, daß das Hydrophobiermittel ein Mercaptotetrazol, ein Mercaptotriazol oder ein Mercapto-oxadiazol ist.

7. Verfahren nach Anspruch 5 oder 6, dadurch gekennzeichnet, daß die alkalische Verarbeitungsflüssigkeit eine Mischung von zwei oder mehr Hydrophobiermitteln enthält.

8. Verfahren nach irgendwelchem der vorstehenden Ansprüche, dadurch gekennzeichnet, daß die Silberhalogenidemulsionsschicht ein hydrophiles Kolloid in einem Gewichtsverhältnis bezogen auf die Menge als AgNO₃ ausgedrucktes Silberhalogenid von nicht mehr als 1,2 enthält.

## Revendications

1. Procédé pour préparer une plaque d'impression lithographique comprenant les étapes consistant à :
- exposer en forme d'image un élément formateur d'image comprenant, sur un support, une couche d'émulsion à l'halogénure d'argent et une couche contenant des germes de développement physique, et
- développer un élément formateur d'image ainsi obtenu exposé en forme d'image, en utilisant un liquide de traitement alcalin en présence d'un composé méso-ionique et d'un agent développateur;
caractérisé en ce que ledit élément formateur d'image comprend de l'halogénure d'argent en une quantité, exprimée comme AgNO₃, de 0,7 g/m à 1,3 g/m.

2. Procédé selon la revendication 1, dans lequel ledit composé méso-ionique est présent dans ledit liquide de traitement alcalin.

3. Procédé selon la revendication 2, dans lequel ledit composé méso-ionique répond à la formule ci-après: 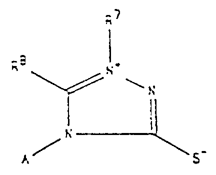 dans laquelle R⁷ et R⁸ représentent, chacun indépendamment l'un de l'autre, un groupe alkyle, un groupe alcényle, un groupe cycloalkyle, un groupe aralkyle, un groupe aryle ou un groupe hétérocyclique, chacun de ces groupes pouvant être substitué ou non;
A représente un groupe alkyle, un groupe alcényle, un groupe cycloalkyle, un groupe aralkyle, un groupe aryle, un groupe hétérocyclique, chacun de ces groupes pouvant être substitué, ou représente -NR⁹R¹⁰ où R⁹ et R¹⁰ représentent, chacun indépendamment l'un de l'autre, un atome d'hydrogène, un groupe alkyle substitué ou non substitué ou un groupe aryle substitué ou non substitué ou encore dans laquelle R⁷ et R⁸ ou bien R⁸ et A ou encore R⁹ et R¹⁰, ensemble avec les atomes auxquels ils sont fixés, représentent les atomes nécessaires pour former un noyau penta- ou hexagonal.

4. Procédé selon la revendication 2 ou 3, àans lequel ledit liquide de traitement alcalin comprend en outre une alcanolamine et/ou un thioéther.

5. Procédé selon l'une quelconque des revendications ci-dessus, dans lequel ledit liquide de traitement alcalin comprend un agent qui rend hydrophobe.

6. Procédé selon la revendication 5, dans lequel ledit agent qui rend hydrophobe est choisi parmi le groupe constitué par un mercaptotriazole, un mercaptotétrazole et un mercaptooxadiazole.

7. Procédé selon le revendication 5 ou 6, dans lequel ledit liquide de traitement alcalin comprend un mélange de deux agents ou plus qui rendent hydrophobe.

8. Procédé selon l'une quelconque des revendications ci-dessus, dans lequel ladite couche d'émulsion à l'halogénure d'argent comprend un colloïde hydrophile dans un rapport pondéral à la quantité de l'halogénure d'argent, exprimée comme AgNO₃, qui n'est pas supérieur à 1,2.
